Europäisches Patentamt

**European Patent Office**

Office européen des brevets

(11) Publication number:   **0 259 108**
A1

(12)

# EUROPEAN PATENT APPLICATION

(21) Application number: **87307626.9**

(22) Date of filing: **28.08.87**

(51) Int. Cl.⁴: **H 05 K 9/00**
**E 06 B 5/18**

(30) Priority: **30.08.86 GB 8621029**
**30.08.86 GB 8621030**

(43) Date of publication of application:
**09.03.88   Bulletin   88/10**

(84) Designated Contracting States: **DE FR NL**

(71) Applicant: **THE MARCONI COMPANY LIMITED**
**The Grove Warren Lane**
**Stanmore Middlesex HA7 4LY (GB)**

(72) Inventor: **Henderson, William Iain Mackie**
**91 Edge Hill Darras Hall**
**Ponteland Northumberland NE20 9JQ (GB)**

**Morrison, David John**
**5 Hobart§Whitley Bay**
**Tyne & Wear NE 26 3TA (GB)**

**Smith, Moira**
**19 Foxhills Covert**
**Wickam Newcastle NE16 5TN (GB)**

**Thornley, David John**
**4 Sunny Brae Ryton**
**Tyne & Wear NE40 4JB (GB)**

**Leask, Samuel Hall**
**27 Walworth Avenue**
**Narsden Estate South Shields NE34 7EP (GB)**

**Matthews, Christopher F.**
**Dere Hollow**
**Riding Hill Northumberland NE44 5DQ (GB)**

(74) Representative: **Tolfree, Roger Keith**
**GEC p.l.c. Central Patent Department Chelmsford Office**
**Marconi Research Centre West Hanningfield Road**
**Great Baddow Chelmsford Essex CM2 8HN (GB)**

(54) **A door latch or lock mechanism.**

(57)   A door latch or lock designed to exclude electromagnetic interference (e.m.i.) has co-operating sliding annular surfaces (3A, 7A) on the door handle (3) and on a bearing block (7) in which the door spindle (6) rotates. These surfaces are electrically conductive and are urged together under spring action (15) to provide an effective shield against e.m.i. The door spindle is of insulating material which prevents electromagnetic interference being transmitted along it from the outside to the inside of the door.

Fig.2.

EP 0 259 108 A1

**Description**

A Door Latch or Lock Mechanism

This invention relates to a door latch or lock mechanism. It arose in the design of a transportable container designed to shield electronic equipment from electromagnetic interference for which purpose it was provided with conductive wall and door panels. A particular problem which arose in the design was the possibility of electromagnetic interference leaking through the door latch or lock mechanism and the invention arose in an endeavour to reduce or eliminate this possibility.

This invention provides a door latch or lock mechanism designed to prevent leakage of electromagnetic interference and comprising: a handle and spindle assembly which is rotatable about an axis and which has, associated with it, a first electrically conductive surface facing in a direction which has a component in the direction of the axis; a bearing block which receives the said assembly in such a way as to allow rotation thereof about its axis and which has, associated with it, a second electrically conductive surface surrounding the axis and lying against the first surface; and resilient means which urges the first and second surfaces together to prevent leakage or electromagnetic interference between them.

The aforementioned "first" and "second" surfaces are preferably in a plane perpendicular to the axis of rotation of the spindle: but this is not essential. For example it would be possible to use co-operating conical surfaces.

The resilient means can conveniently be provided by a conical spring washer.

It has been found that the handle on the outside of a container can act as an aerial, to receive radiation which is then transmitted through the door spindle to a handle on the inside of the container from which it is reradiated. To prevent this it is proposed to make the spindle of insulating material. Where this technique is employed it is beneficial for the handle to cover one end of the spindle and to define the said "first" electrically conductive surface; thereby preventing radiation from being transmitted directly through the insulating spindle.

One way in which the invention may be performed will now be described by way of example with reference to the accompanying. drawings in which:-

    Fig. 1 is a side elevation of a door and door frame forming part of a shelter for electronic equipment as viewed from the inside of the door;

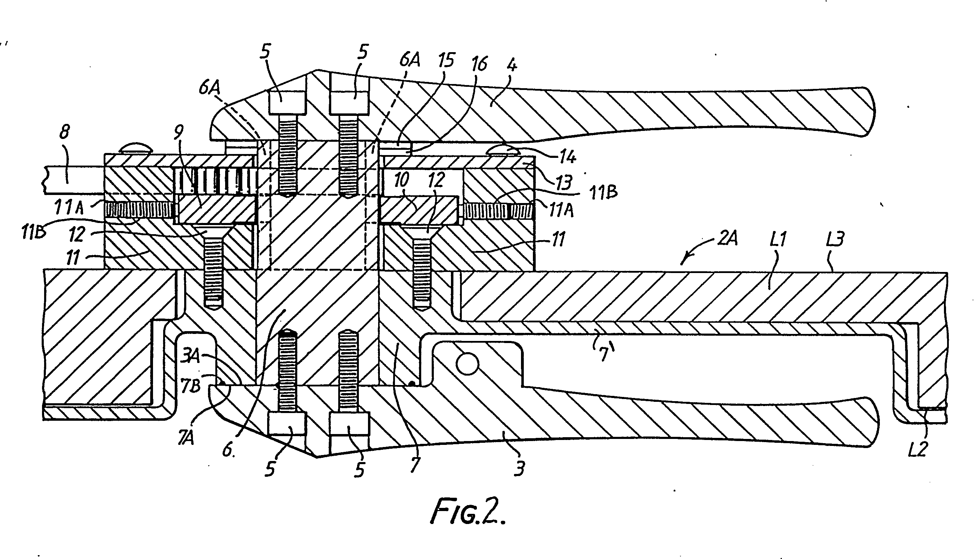

    Fig. 2 is a horizontal cross-section through the line II-II of fig. 1 showing detailed construction of the door handles and bolt operating mechanisms;

    Fig. 3 an elevational view of the bolt operating mechanisms seen from the inside of the door with the handle 4, plate 13 and spacer 12 of fig. 2 removed to reveal rack and pinion mechanisms; and

    Fig. 4 is a vertical cross-section through the line IV-IV of fig. 1.

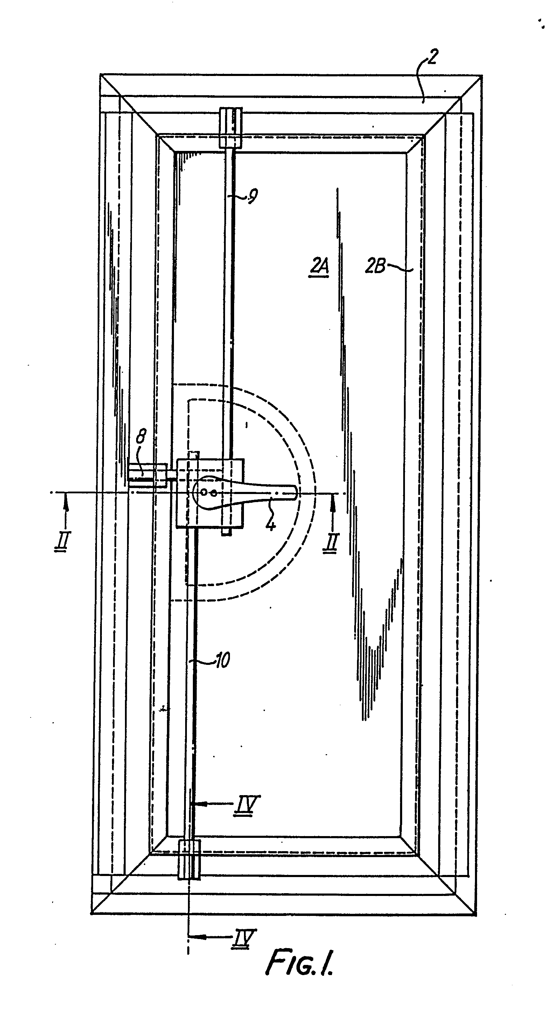

The illustrated construction is part of a shelter designed to exclude electromagnetic interference, such as is used for portable radar equipment. One wall of the shelter has a door frame 1 (fig. 1). The door frame 1 receives a door 2 having a hinged side 2A and unhinged sides 2B,2C and 2D. The door frame 1 and door 2 have seals which will be described in detail later and which are compressed when the door is closed. This compression of the seals requires a large closing force to be applied to the door and this force is applied by the mechanism which will now be described.

The door has external and internal handles 3 and 4 which are secured by bolts 5 to a spindle or shaft 6 made of synthetic plastics material. The use of the synthetic plastics material for this purpose is significant because of its electrically insulating properties. It ensures that there is no continuous conductive path between the external handle 3 and the internal handle 4 which could transmit electromagnetic interference from the outside to the inside of the shelter. Thus the handle 3 is unable to act as a receiving aerial which transmits electromagnetic interference through the door spindle to the internal handle, as could occur if the spindle 6 were made of electrically conductive material as in conventional systems.

The shaft 6 is mounted for rotation in a bore formed in a bearing block 7 which has a flange 7' fitted in a recessed portion of the door 2 into which the handle 3 fits.

The shaft 6 has teeth 6A which engage toothed portions 8A,9A,10A on three door bolts 8,9,10 serving to secure the sides 2B,2C,2D of the door.

The bolts 8, 9 and 10 are guided for longitudinal movement in respective channels 11A, 11B, 11C machined in a guide block 11. The block 11 also has threaded bores 11A which receive threaded PTFE plugs 11B. The latter bear against the bolts 8,9 and 10 to hold them in accurate engagement with the shaft 6. The block 11 is secured by screws 12 to the bearing block 7 and the bolts are retained in their respective channels by a cover plate 13 secured to the guide block 11 by screws 14.

Mating surfaces 3A and 7A of components 3 and 7 are held together by the action of a conical spring washer 15 acting between the handle 4 and a plain PTFE washer 16 which rests against the cover plate 13. This ensures an effective continuity of a conductive outer surface of the door, the components L2, 7 and 3 all making electrical contact with each other. It should be noted that the continuity of these conductive surfaces is obtained despite the need to use an insulating door spindle 6. A circular groove is machined in surface 7A and receives an O-ring 7B to provide an effective weatherproof seal without the use of oil or grease which would impair the electrical contact between surfaces 7A and 3A.

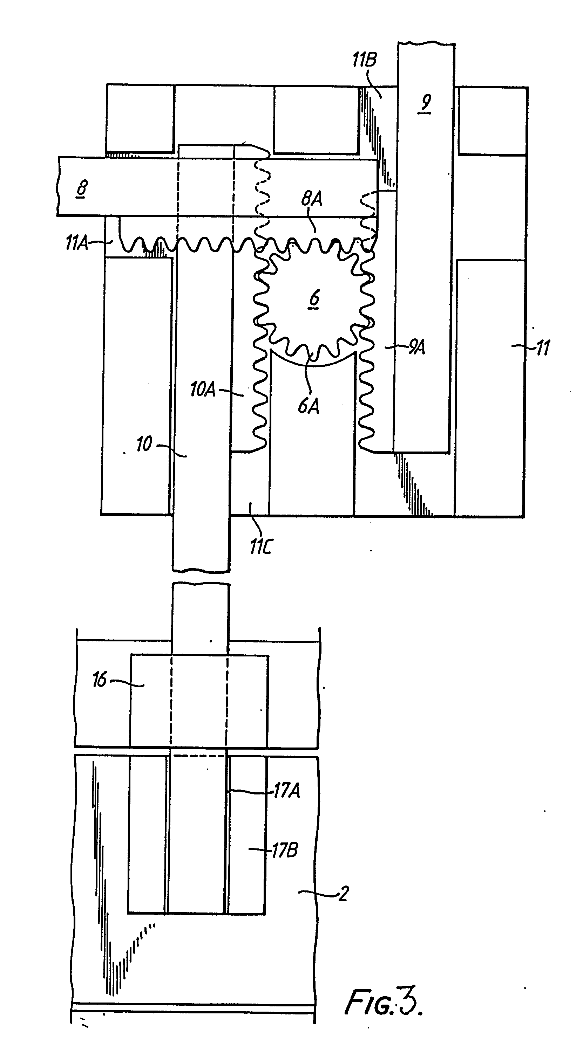

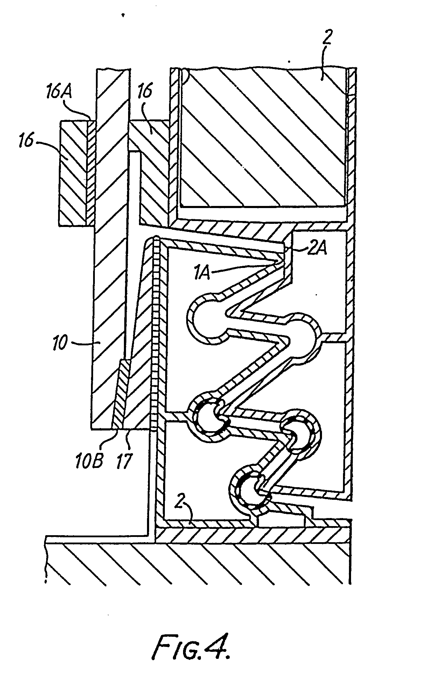

A lower end of the bolt 10 is shown on figures 3 and 4. The three ends of the other bolts are similar and therefore will not be described on detail though they are shown on figure 1.

Referring now to figure 4, the lower end of the bolt 10 is guided by a guide 16 having a PTFE bearing 16A. The bolt 10 also has, at its end, a block 10B of PTFE formed with a bearing surface arranged at an angle to the direction of motion of the bolt. This bearing surface bears against a similarly angled surface of a stop member 17 secured to the door frame 1.

When the bolt is shot by the rack and pinion action of the teeth on members 6 and 10, the co-operating surfaces of block 10B and stop 17 cause a wedging or camming action serving to press the door into a recess defined by the door frame 1 until meeting surfaces 1A and 2A of the frame 1 and door 2 meet in the position illustrated in figure 4.

From figure 4 it will be noted that the edge of the door 2 and the frame 1 are specially shaped with interleaving ridges and depressions. These form a seal against electromagnetic interference. Some of the depressions contain compressible seals 19 formed from rubber tubing covered with a metal braid. When the door is closed to the position illustrated in figure 4 the seals are compressed, this requiring a considerable force which is adequately provided for by the camming action of the three bolts.

## Claims

1. A door latch or lock mechanism designed to prevent leakage of electromagnetic interference and comprising; a handle (4) and spindle assembly which is rotatable about an axis characterised in that the spindle assembly has, associated with it, a first electrically conductive surface facing in a direction which has a component in the direction of the axis; a bearing block which receives the said assembly in such a way as to allow rotation thereof about its axis and which has, associated with it, a second electrically conductive surface surrounding the axis and lying against the first surface; and resilient means which urges the first and second surfaces together to prevent leakage of electromagnetic interference between them.

2. A mechanism according to claim 1 in which the resilient means comprises a conical spring washer which acts between two surfaces to urge them apart whilst forming a conductive seal between them.

3. A mechanism according to claim 1 or 2 in which the spindle is of electrically insulating material and in which at least one of the handles is conductive, covers one end of the spindle and defines the said first electrically conductive surface.

4. A door designed to exclude electromagnetic radiation including: two handles as herein defined, one on each side of the door; and electrically insulating shaft linking the two handles; and a door securing mechanism operated by the shaft.

5. A door as claimed in claim 1 where the insulating shaft passes through a conductive member held in electrical contact with one handle by spring means to form an electromagnetic radiation proof structure.

6. A door as claimed in claim 2 where the spring means is a conductive compression spring between the conductive member and the door so as to form an electromagnetic radiation proof seal.

7. A door as claimed in claim 3 where said conductive compression spring is a metallic cone washer.

8. An electromagnetic radiation proof enclosure including a door as claimed in claim 4,5,6 or 7.

0259108

FIG.1.

FIG.2.

0259108

FIG.3.

0259108

FIG.4.

European Patent Office

EUROPEAN SEARCH REPORT

Application Number

EP 87 30 7626

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | EP-A-0 095 743 (OY EURAMECANO AB)<br>* page 6, lines 2-11; figure 4 *<br>--- | 1 | H 05 K 9/00<br>E 06 B 5/18 |
| A | DE-C-1 139 967 (COMPRIFALT-IBS BAUSPEZIALITÄTEN)<br>* column 3, lines 52-56; column 5, lines 13-19; figure 5 *<br>--- | 1 | |
| A | US-A-4 571 449 (J.N. LINDENBERGER et al.)<br>* column 8, lines 25-38; figure 3 *<br>----- | 1 | |
| | | | TECHNICAL FIELDS SEARCHED (Int. Cl.4)<br><br>H 05 K 9/00<br>E 06 B 5/00 |

The present search report has been drawn up for all claims

| Place of search | Date of completion of the search | Examiner |
|---|---|---|
| BERLIN | 06-11-1987 | LEOUFFRE M. |

EPO FORM 1503 03.82 (P0401)